Europäisches Patentamt

(19) European Patent Office

Office européen des brevets

(11) Publication number: **0 245 915**

**A2**

## (12) EUROPEAN PATENT APPLICATION

(21) Application number: **87300892.4**

(22) Date of filing: **02.02.87**

(51) Int. Cl.⁴: **G01R 31/28**

(30) Priority: **02.05.86 US 859163**

(43) Date of publication of application:
**19.11.87 Bulletin 87/47**

(84) Designated Contracting States:
**DE FR GB NL**

(71) Applicant: **TEKTRONIX, INC.**
**Tektronix Industrial Park D/S Y3-121 4900**
**S.W. Griffith Drive P.O. Box 500**
**Beaverton Oregon 97077(US)**

(72) Inventor: **Peterson III, Sigurd H.**
**20418 S.W. Almond Court**
**Aloha Oregon 97006(US)**
Inventor: **Dietrich, Randolph I.**
**6636 S.W. Griffin Drive**
**Portland Oregon 97223(US)**

(74) Representative: **Wombwell, Francis et al**
**Potts, Kerr & Co. 15, Hamilton Square**
**Birkenhead Merseyside L41 6BR(GB)**

(54) **Logic signal state and timing display.**

(57) A method and apparatus for displaying the timing and state behavior of a group of logic signals is disclosed. The logic signals are represented by a sequence of period indicating symbols such as light and dark colored rectangles displayed on a screen. The length of each light rectangle represents a different period of signal stability during which none of the logic signals of the group changed state, while the length of each dark rectangle represents a period of signal instability during which at least one of the logic signals of the group changed state. When a light rectangle is sufficiently wide, a numerical indication of the states of the logic signals during the period represented by the light rectangle is superimposed over the rectangle.

FIG. 1

# LOGIC SIGNAL STATE AND TIMING DISPLAY

## Background of the Invention

The present invention relates generally to a method and apparatus for displaying timing and state characteristics of logic signals, and more specifically to a method and apparatus for displaying a compact representation of timing and state characteristics of a group of logic signals.

In various kinds of electronic apparatus, logic signal processing techniques have become increasingly popular as a result of the development of microprocessors and computers. Oscilloscopes, logic probes and logic analyzers are utilized for developing, calibrating and trouble-shooting electronic apparatus employing digital logic circuits. Logic analyzers are ideal for monitoring the performance of digital electronic apparatus because they can store multi-channel input logic signals as data in an acquisition memory and can display the data stored in the memory on a display means such as a cathode ray tube (CRT).

Typically there are two display modes in logic analyzers, a timing display mode and a state display mode. In the timing display mode, individual logic signals are graphically represented as binary waveforms drawn along a horizontal time scale, different waveforms being vertically separated but horizontally aligned so as to graphically depict the timing relationships between state changes of different logic signals. In the state display mode, logic signals are grouped into sets and then characterized as a list of data words each representing the state of a logic signal set at a particular time. For instance, all of the data lines of a computer bus may be grouped into one set and all of the address lines of the bus may be grouped into another set and the values of data carried on the data and address lines at a succession of times would be displayed as a succession of binary, octal or hexadecimal words.

The state display mode represents the behavior of a group of logic signals in a compact manner but much of the detail in the timing relationships between individual logic signals is lost. The timing display mode shows detailed timing relationships but when timing data representing a great many logic signals is acquired, it is usually not possible to display waveforms representing every signal at the same time and it is often difficult and time consuming to determine from a timing mode display the value of data carried by a group of logic signals, such as may be carried on the data or address lines of a computer bus.

What is needed and would be useful is a method and apparatus for displaying timing and state information characterizing a group of logic signals in a more compact manner than is possible under the prior art timing display mode but without substantial loss of timing detail associated with the state display mode of logic analyzer operation.

## Summary of the Invention

In accordance with one aspect of the invention, a logic analyzer is adapted to display a compact representation of the timing and state behavior of a group of logic signals. The logic signal group is represented by a horizontal sequence of light and dark colored rectangles or other suitable graphics symbols displayed on a screen. The width of each light rectangle represents the duration of a "quiescent" time period during which the state of each logic signal of the group remained constant. The width of each dark rectangle indicates the duration of a "transition" time period during which at least one of the logic signals changed state. When a light rectangle is sufficiently wide, a numerical indication of the states of the logic signals during the period of stability represented by the rectangle width is superimposed over the rectangle. The numerical indications represent the states of each logic signal as compactly as the state display mode of the prior art while the pattern of light and dark rectangles convey nearly as much state change timing information as the prior art timing display mode.

In accordance with another aspect of the invention, the relationship between the width of the rectangles and the time periods represented by the rectangles can be increased or decreased so as to expand or contract the time scale of the display. When the time scale is contracted, a longer portion of the logic signals can be represented, and when the time scale is expanded, the rectangles become wider and more light rectangles are wide enough to permit display of the numerical indication of the states of the logic signals.

It is accordingly an object of the invention to provide a new and improved method and apparatus for compactly displaying on a screen timing and state information characterizing a group of logic signals.

The subject matter of the present invention is particularly pointed out and distinctly claimed in the concluding portion of this specification. However, both the organization and method of operation, together with further advantages and objects thereof, may best be understood by reference to the following description taken in connection with accompanying drawings wherein like reference characters refer to like elements.

## Drawings

FIG. 1 is a block diagram of a logic analyzer utilizing the present invention;

FIG. 2 comprises a display of a waveform timing and state information including busform displays according to the present invention;

FIG. 3 is a block diagram of the display control circuit of FIG. 1;

FIGS. 4A - 4E illustrate graphics characters suitable for creating the display of FIG. 2; and

FIG. 5 is a flow chart for a computer program for converting logic signal data into busform display characters.

## Detailed Description

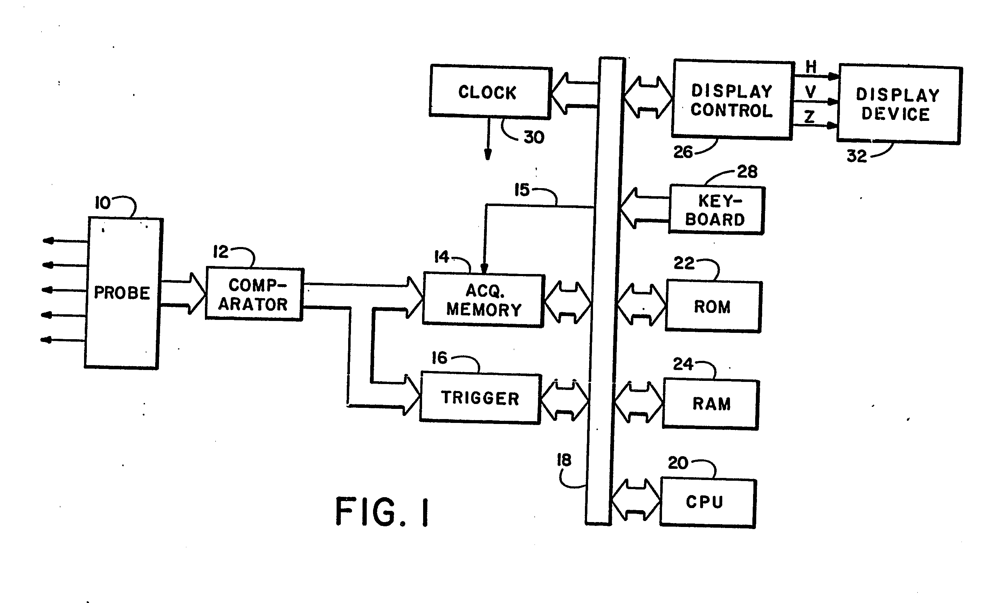

Referring to FIG. 1, there is shown a block diagram of a logic analyzer utilizing the present invention. Logic signals detected by a probe 10 are applied to a comparator circuit 12 which compares the logic signals with a predetermined level, adjusts them to an appropriate high or low logic level, and applies them as inputs to an acquisition memory 14 and a trigger circuit 16.

Memory 14 is a high speed random access memory (RAM) and trigger circuit 16 includes a word recognizer and a counter. Data acquisition is initiated by a write start command transmitted to memory 14 over a line 15 of a bus 18. Bus 18 is connected to a central processing unit (CPU) 20, such as an Intel Corporation type 8080 microprocessor, and to the various other devices shown in FIG. 1, and serves to transfer data, address, and control signals between the connected units. The 8080 microprocessor is fully described in "MCS-80 User's Manual" published by the Intel Corporation. CPU 20 acts as logic arithmetic and processing means for controlling the logic analyzer, using a RAM 24 as a temporary memory in accordance with firmware (microcode instructions) stored in a read only memory (ROM) 22. When the word recognizer in trigger circuit 16 detects a predetermined pattern in the logic signals, it generates a write stop signal, applied to acquisition memory 14 through bus 18, so as to stop data acquisition by memory 14.

A keyboard 28 connected to bus 18 provides means for an operator to input data, control signals and the like into the logic analyzer. A clock signal generator 30 applies a system clock signal to each block, the clock signal frequency being determined by data provided by CPU 20 via bus 18. A display control circuit 26 supplies a horizontal control signal H, a vertical control signal V and an intensity signal Z to a raster scan display device 32 such as a CRT, the intensity signal being controlled according to display information provided to the display control circuit 26 via bus 18 from a display information storage area in RAM 24.

The operation of the logic analyzer shown in FIG. 1 will be discussed beginning with input data acquisition and ending with the input data being displayed on display device 32. Initially, an operator connects various input channels of probe 10 to a circuit to be tested and provides information to the logic analyzer via keyboard 28 regarding how the probe channels are to be grouped and ordered. For instance if the probe is connected to a computer bus, the operator may indicate that the probe channels connected to data lines of the computer bus form one such group and may indicate that the channels of this group are to be ordered according to the order of significance of data bits carried on the data lines. Similarly, the operator may identify the probe channels connected to address lines of the computer bus as a second group and may specify that the group be ordered according to the order of significance of data bits carried on the address lines.

The remaining sequential steps in the operation of the logic analyzer are as follows:

(1) When the operator enters an acquisition start command via keyboard 28, the write command signal is applied to acquisition memory 14 by CPU 20.

(2) Memory 14 acquires input logic signal data from comparator 12 and stores them sequentially in predetermined memory areas.

(3) When trigger circuit 16 detects a trigger word in the input data from comparator 12 and counts a predetermined number of clock signals, trigger circuit 16 applies the write stop signal to memory 14 and memory 14 stops acquiring data.

(4) The operator instructs the logic analyzer via keyboard 28 to display a portion of the data stored in memory 14.

(5) CPU 20 converts the stored data in memory 14 into display data which is stored in the display area of RAM 24.

(6) The contents of the display area of RAM 24 are displayed on display device 32 through display control circuit 26.

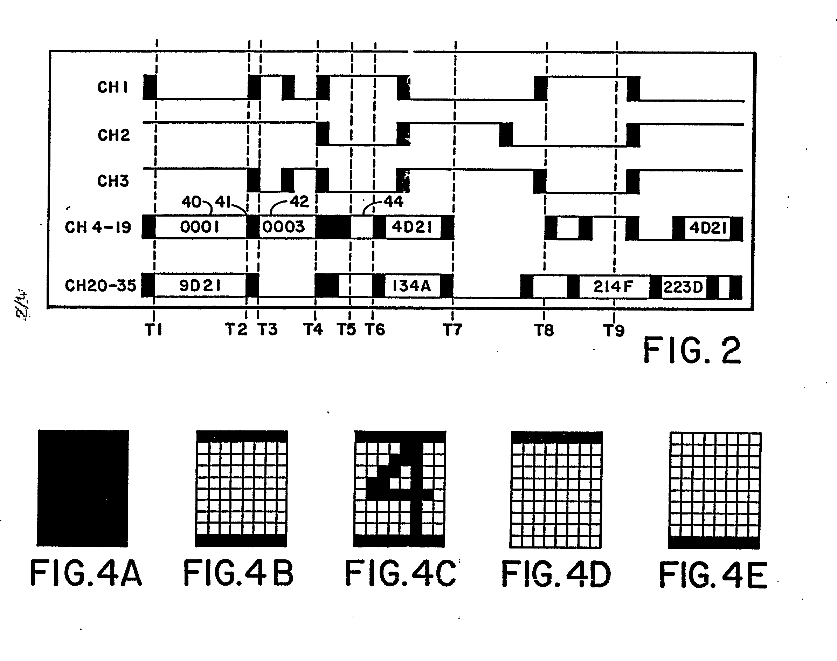

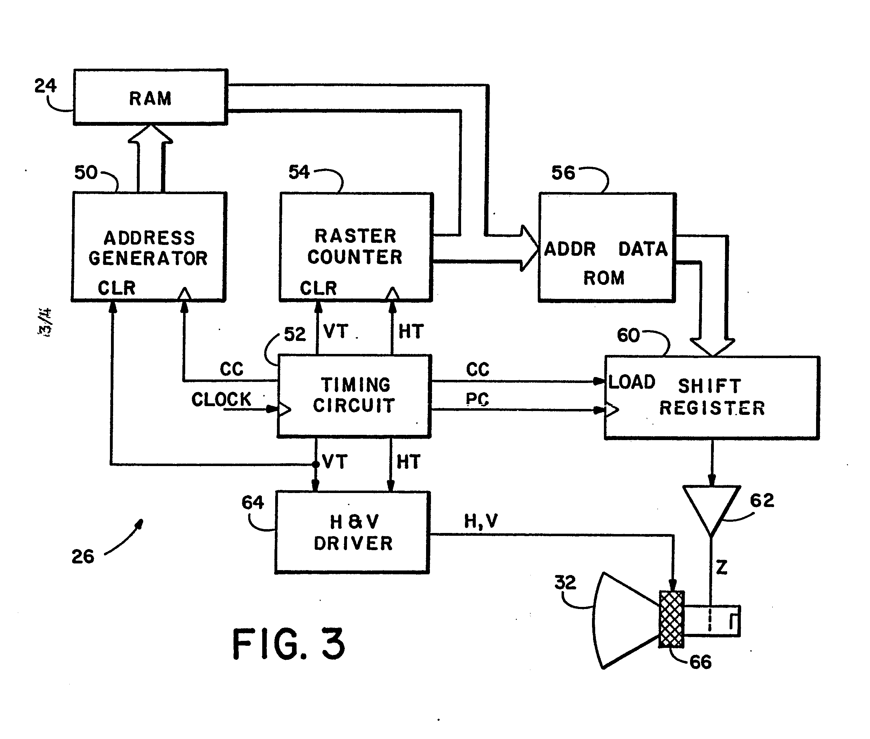

The present invention relates to the fifth and sixth steps of the above described logic analyzer operation. FIG. 2 shows a typical display produced by the logic analyzer in response to three individual logic signals and two groups of logic signals. The three individual signals appear on logic analyzer probe channels 1, 2 and 3 and represent, for instance, signals appearing on control lines of a computer bus. In the example of FIG. 2, the operator has not specified these three signals as being part of signal groups and the logic analyzer represents each signal in the form of a conventional timing diagram. The operator has specified that one group of sixteen input logic signals appear on probe channels 4-19 while a second group of sixteen logic signals appear on probe channels 20-35. The two groups of logic signals may, for example, have been acquired from sixteen data and sixteen address lines, respectively, of a computer bus. The state and timing behavior of these two groups of logic signals are represented by busform displays according to the present invention.

In creating a busform display representing the timing and state behavior of a group of logic signals, the CPU 20 checks the data in acquisition memory 14 of FIG. 1 to determine the duration of "quiescent" time periods during which the states of all of the logic signals of the group remain unchanged, and the duration of "transition" time periods during which one or more of the logic signals of the group changed state. The CPU also determines a data value represented by the logic signals of the group during each quiescent time period. The CPU 10 then computes and stores in the display area of RAM 24 character data which tells display control circuit 26 to create a busform representing the behavior of the logic signal group. The busform comprises a horizontal sequence of light and dark colored rectangles on display device 32, each light rectangle representing one of the quiescent periods and each dark rectangle representing one of the transition periods. The width of each rectangle is proportional to the duration of the time period it represents. When a light rectangle is sufficiently wide, a numerical indication of the states of the logic signals of the group during the corresponding quiescent period is displayed within the rectangle.

Referring to FIG. 2, one such busform represents the timing and state behavior of the data lines carried on channels 4-19. A first light rectangle 40 indicates that states of all sixteen data lines remained constant between time T1 and time T2. (The time indications T1, T2, etc. and the associated dashed vertical lines are shown for reference purposes only and are not actually included in the display.) The value of data carried on the sixteen data lines between times T1 and T2 is indicated by the hexadecimal number 0001 within rectangle 40, indicating that line carrying the least significant data bit was high while all other lines were low. The duration of the time period between times T1 and T2 is represented by the width of rectangle 40. Between time T2 and time T3, the state of one of the sixteen signals on channels 4-19 (the second least significant) changed to a high logic level and thereafter the states of all 16 data signals remain constant until time T4. The transition time period between times T2 and T3 is represented by the width of a dark rectangle 41 and the stable time period between times T3 and T4 is represented by another light rectangle 42. The states of the data lines between T3 and T4 are collectively represented by the number 0003 inside rectangle 42. The state of at least one of the sixteen data lines changes between time T4 and time T5 and the states remain constant until time T6. Since the time period between T5 and T6 is relatively short, the width of a rectangle 44 representing the quiescent time period is too small to contain a four digit hexidecimal number representing the states of the 16 data lines and therefore the states of the data lines during that time cannot be determined from the illustrated busform display.

The data carried on channels 4-19 has a value of 0000 during a quiescent period between times T7 and T8. This period could also be represented by a light rectangle containing the value 0000. However in the preferred embodiment of the invention, when each of a group of lines is at a low logic level, the period is represented by the length of the lower line of a light rectangle, the upper line being suppressed, and no number is displayed. Similarly, when each of a group of lines is at a high logic level, the period is represented by the length of the top line of a light rectangle, the lower line and the state indicating number also being suppressed. This enables a user to observe the value of data carried by a group of lines when the rectangle is otherwise too small to contain the state indicating number, provided that the lines are all at high logic levels or all at low logic levels. For example at time T9, the data lines (channels 4-19) are all at high logic levels.

The busform displays of FIG. 2 permit the display of timing and state information for many more waveforms than is possible in a traditional waveform timing display while displaying detailed timing relationships between logic signals. For instance the display of timing information for channels 4-19 would require 16 conventional single channel waveforms (such as utilized to depict the logic signal on channel 1) and would therefore require sixteen times as much space as a busform display according to the present invention. The relationships between the data lines on channels 4-19, the address lines on channels 20-35 and control lines on channels 1-3 are easily seen. For instance at time T9, channel 1 was high, channels 2 and 3 were low, channels 4-19 were all high, and channels 19-34 were of states indicated by the number 214F.

When a light rectangle (such as rectangle 44) is too small to contain data indicating the states of the logic signals of a channel group, the actual states of the channels during the corresponding period of state change inactivity cannot be determined from the display. However the present invention permits an operator to increase or decrease the ratio of the width of the rectangles to the duration of the time periods represented by the rectangles. When the ratio is increased, the time scale of each busform is expanded so that relatively short quiescent time periods are represented by rectangles of sufficient width to permit display of a state indicating number. With the expanded time scale, the duration of the displayed portion of input logic signals decreases.

The busform display of FIG. 2, according to the present invention, can be created by using a special character set as illustrated in FIGS. 4A-4E. In the preferred embodiment of the invention, each character is eight pixels wide and 10 pixels high and in FIGS. 4B-4E each small square represents a pixel. The characters of FIGS. 4B and 4C are utilized to form the inner portions of a light rectangle. The character of FIG. 4B, comprising an upper and lower bar, is utilized to form the inner sections of a rectangle containing no digits. Characters similar to that shown in FIG. 4C are utilized to form the inner portions of a rectangle containing a digit from 0-F (hexidecimal). The solid dark character of FIG. 4A is utilized to create the dark rectangles representing transition periods. A single upper bar character of FIG. 4D forms a central portion of a single upper bar line (as illustrated in FIG. 2, for channels 4-19 at time T9) while a single lower bar character of FIG. 4E is used to form a central portion of a single lower bar line (for example, FIG. 2, channels 4-19 between times T7 and T8). Note that in order for a four digit state indicating number to be displayed, a light rectangle must be wide enough to include at least four characters similar to that shown in FIG. 4C.

The channel data from comparator 12 of FIG. 1 is sampled periodically and stored at successive addresses in the acquisition memory 14. Therefore the data stored in acquisition memory 14 over a particular address range represents the states of the input channels over a time period proportional to the address range. The operator initially inputs via keyboard 28 data indicating the time period resolution of the display, i.e., the "unit time period" represented by the width of the smallest rectangle on a busform display. Since the busform is formed by characters, the width of the smallest rectangle in display pixels is equal to the pixel width of a character, eight pixels in the present example. The operator therefore can expand or contract the time scale of the display by decreasing or increasing the duration of the unit time period.

After the channel data is acquired and stored in the acquisition memory 14, the CPU reads the data acquired during each of a succession of unit time periods, groups and orders the data according to the channel grouping and ordering information provided by the operator, and then answers the following two questions about the data associated with each group acquired during each unit time period:

(1) Did the state of any channel in a group change during the unit time period?

(2) If the state of every channel of a group was constant during the unit time period, what was the value of the data represented by channel group during the time period? On the basis of these answers, the CPU 20 determines and stores character data in the display area of memory 24 to form the busform display according to the present invention. The display control circuit 26 then produces the display on display device 32 according to the stored character data.

Referring to FIG. 3, the display control circuit 26 of FIG. 1, shown in more detailed block diagram form, is adapted to acquire character data from memory 24 and display it on display device 32, for example a 640×400 pixel raster scan CRT. A timing circuit 52, comprising a set of counters, counts system clock pulses to produce timing control signals for the display control circuit 26. A horizontal timing signal HT is produced every 640 clock pulses to indicate when a new raster scan line is initiated and a vertical timing signal VT is produced every 640×400 clock pulses to indicate when an entire screen has been updated. The HT and VT signals are applied to a horizontal and vertical scan driver 64 which produces the horizontal and vertical signals H and V transmitted to the yoke 66 of the CRT 32 to control beam movement.

Timing circuit 52 also produces a character count signal CC every eight clock pulses and a pixel count signal PC after every clock pulse. The character count signal CC controls a clock input of an address generator 50 for producing an address output applied to memory 24 containing characters to be displayed on CRT 32. The character data currently addressed in memory 24 is transmitted to the address terminals of a ROM 56. The timing circuit 52 also transmits the horizontal timing signal HT to a clock input of a raster counter 54. Each time the timing circuit generates a horizontal timing signal, the output data of the raster counter 54 is incremented by one. On receipt of every 10th HT signal, the output data of raster counter 54 is reset to zero. The raster counter output data is applied to additional address terminals of ROM 56 which converts the character data from memory 24 and the raster count to an eight bit pixel control word transmitted to a shift register 60. The character count signal CC signal controls the loading of pixel control data into the shift register 60 and when the CC signal is asserted, the pixel data from ROM 56 is loaded into the shift register. The pixel count signal PC from the timing circuit 52 clocks the shift register, causing the shift register to transmit the eight pixel bits in serial fashion to an amplifier 62 which controls the Z axis of the CRT 32 such that when a pixel data bit is high, a pixel is illuminated.

When the timing circuit 52 generates a VT signal, the CRT 32 beam is reset to the upper left hand pixel of the display. On receipt of the HT signal, the driver 64 initiates the horizontal control signal H causing the beam to move horizontally across the screen to the right along the top raster scan line. The VT output signal of timing circuit 52 also clears counters in address generator 50 and raster counter 54 such that the output of address generator 50 is reset to the address of the display area of memory 24, wherein the character to be displayed in the upper left hand corner of CRT 32 is stored, and the output of raster counter 54 is set to zero. The character data in memory 24 is transmitted to ROM 56 and the resulting eight bit output word of ROM 56 controls the states of the top eight pixels of the character to be displayed in the upper left hand corner of CRT 32. This data is loaded into shift register 60 on receipt of the next character count signal CC, and is serially transmitted to amplifier 62 when clocked by the pixel count signal PC. The resulting output of amplifier 62 causes the CRT to illuminate appropriate ones of the first eight pixels so as to form the upper eight pixel rows of the first character.

The character count signal CC which loaded data into shift register 60 also causes the address generator 50 to increment the memory 24 address by one so that the RAM outputs character data indicating the next character to the right from the upper left corner of the display. Since the raster counter 54 output remains the same, the HT signal having remained unasserted, ROM 56 outputs the pixel data for the top eight pixels of the second character and these bits are loaded into shift register 60 and clocked through amplifier 62 to control the display of the top row of pixels for the second character. The process is repeated until the top row of pixels all 64 characters in the first row of the display are updated.

The timing circuit 52 then initiates an HT signal, causing driver 64 to start a new horizontal raster scan, vertically shifted downward by one pixel. At the same time, the HT signal causes the raster counter 54 to increment its output by 1 so that the pixel data produced by ROM 56 corresponds to the second row character pixels. Address generator 50 resets its output on the next CC pulse to readdress the character to be displayed in the upper left corner of CRT 32. The pixel scan process continues as described for the first row scan until the second row of pixels has been scanned.

Each time the CRT beam reaches the end of a horizontal raster scan, timing circuit 52 generates an HT signal which increments the count of raster counter 54. Address counter 50 keeps track of the number of times it resets its address output following the end of a horizontal raster scan, and after the 10th reset, corresponding to the end of the 10th raster scan, it begins resetting its output to address the first character of the second row of characters to be displayed at the end of each scan. After 10 more scans it begins resetting its output to address the third character. This process continues until the end of the last scan, at which time the timing circuit 52 transmits another VT signal to the address generator 50 causing it to reset its output to once again address the character to be displayed in the upper left corner of CRT 32.

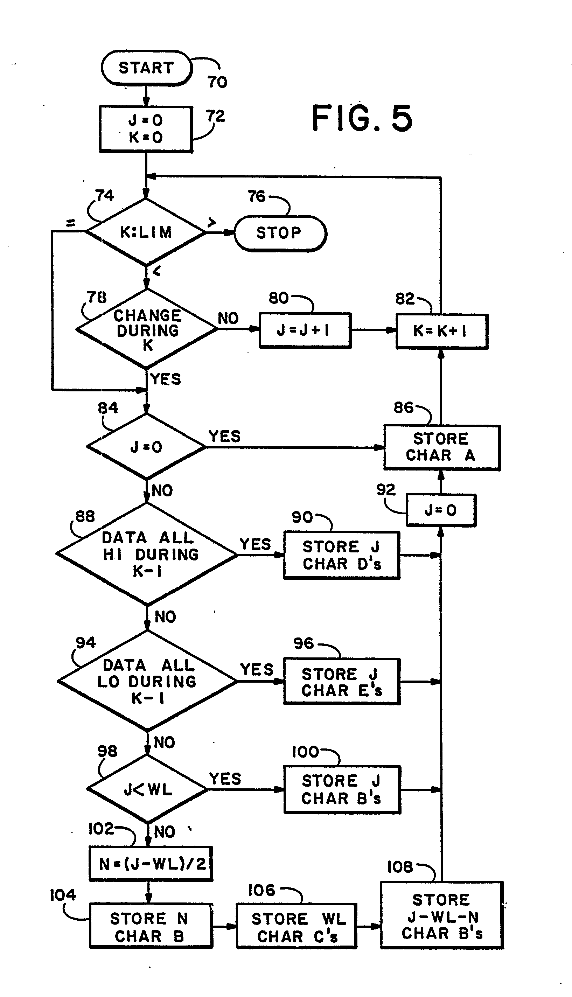

Thus in order to create a busform display such as for channels 4-19 of FIG. 2, it is necessary for the CPU to store the appropriate characters in the display area of memory 24 of FIG. 3. FIG. 5 is a flow chart for a computer program which directs the CPU to select and store in memory 24 the sequence of character data required to produce a busform display for a group of channels. Referring to FIG. 5, the constant LIM is an integer representing the number of characters (line length) required to form a busform and the variable K is an integer which keeps track of the number of characters thus far stored in memory 24 during the process of creating a busform. Since each character represents the behavior of a channel group during a unit time period, and since the characters are stored in the order that they are to be displayed, K also indicates a number of unit time periods between the start of the busform and the period represented by the Kth character stored. The variable J represents the duration in unit time periods of a quiescent period. The constant WL is the number of characters required to display a data value for a group of channels. In the example of FIG. 2, four characters are required to display the data for channels 4-19 so WL would be 4.

Generally, the program checks the channel data acquired during the first time period 0 (i.e., K=0) represented by the busform to see if the value of the channel data changed during the time period. The number of acquisition memory addresses checked determines the actual length of a unit time period and this number is previously determined by data provided by the operator. The channel data for unit time period 1 (K = 1) is checked, followed by the data for time period 2, and so on until it checks the data for the last time period LIM. When the value of data does not change during a currently checked time period, no character data is stored in memory 24 but the counters J and K are incremented. When the value of data changes during a time period, a set of J + 1 characters are stored sequentially in memory 24 to create the portion of the busform extending from the last period of data change to the current period of data change, and J is reset to 0. The process continues until K reaches the limit WL indicating that all of the data has been checked and the appropriate busform characters have been stored in memory 24 in the order that they are to be displayed.

The flow chart of FIG. 5 starts in block 70. The J and K variables are initialized to 0 (block 72) and the value of K is checked (block 74) to determine if the data associated with the last unit time period (LIM) for the busform has been processed. If K is less than LIM, the data acquired during the Kth time period is checked and if no change occurred in state of any signal in the channel group represented by the busform during the Kth time period (block·78), the value of J is incremented (block 80), the value of K is incremented (block 82) and program returns to block 74 where processing is begun of the data for the next time period K + 1. However if the channel data value changed during the Kth time period then the value of J is checked (block 84) to see if it is zero. If it is, then only one character (the character of FIG. 4A) is stored in memory 24 (block 86) since J = 0 indicates the channel data also changed during the last time period K-1. The value of K is then incremented in block 82 with return to block 74.

If J is greater than zero, indicating that the channel group has remained quiescent for the last J periods, then J + 1 characters are stored to represent the behaviour of the channels during the last J + 1 periods. If all of the input channels were in a high state during the previous quiescent period K-1 (block 88) then J characters of the type shown in FIG. 4D are stored (block 90), J is reset to 0 (block 92) and one FIG. 4A character is stored (block 86), thereby forming a busform section such shown in FIG. 2 as for channel 4-19 at time T6. The value of K is incremented (block 82), and the program returns to block 74 to begin processing data for the next unit time period. If all of the channels were in a low state during the previous stable periods (block 94), then J FIG. 4E type characters are stored in the display area of memory (block 90), J is set to 0 (block 92), and one FIG. 4A type character is stored (block 86), thereby forming a busform section similar to that shown in FIG. 2 for channels 20-35 between times T3 and T4.

If the channels were not all high (block 88) and not all low (block 94) during the previous stable periods, and if J is less than the word length WL required for the state data display (block 98), then J FIG. B type characters are stored (block 100), J is set to zero (block 92) and one FIG. 4A character is stored. The stored characters form an empty light rectangle representing a quiescent period such as rectangle 44 of FIG. 2.

Finally, if the channels were not all low (block 94) or all high (block 88), and if J is greater than or equal to the data word length (block 98), then a light rectangle containing the value of the channel group data is displayed with the channel data centered in the rectangle. In block 102 the word length WL is subtracted from J and the result divided by 2 to determine the number N of FIG. 4B type characters to precede the channel data. In block 104 the quantity N of the FIG. 4B characters is stored in the display memory. Then (block 106) the quantity WL of appropriate FIG. C type characters is stored to indicate the value of the channel data during the quiescent period, and thereafter (block 108) the quantity J-WL-N of FIG. 4B type characters is stored in memory to fill out the rest of the inner portion of the rectangle representing the stable time period. J is then set to 0 (block 92) and a FIG. 4B type character is stored in memory (block 92) to close the rectangle and to indicate the start of a transition period.

After the characters have been stored for each stable section of the busform, K is incremented in block 82, and flow reverts back to block 74 where the CPU begins processing the channel data for a next unit time period. When the K reaches the value of LIM (block 74), the data for the last unit time period has been checked. In such case, block 78 is bypassed (i.e., the data of the last time period is assumed to change even if it did not in fact do so) and block 84 is entered. Thereafter the characters necessary to display the last portion of the busform are determined and stored. When K is incremented once more (block 82), the value of K exceeds LIM (block 74) and the process stops in block 76.

Thus the method and apparatus of the present invention provide for the display on a screen of timing and state information characterizing a group of logic signals in a more compact manner than is possible under the prior art timing display mode but without substantial loss of timing detail presented in the state display mode of logic analyzer operation. While in the preferred embodiment of the present invention the busform displays of FIG.

2 are produced using characters shown in FIGS. 4A-4E to produce a sequence of light and dark rectangles, such characters may be modified in many ways to produce busforms which appear somewhat different but which convey the same information regarding the states and timing of a channel. According to the preferred embodiment of the invention, the character of FIG. 4A is such that a series of one or more of these characters creates an "instability indicating symbol" comprising a dark rectangle, the width thereof representing a transition period. However other instability indicating symbols could be created by changing the nature of the character of FIG. 4A. For example, the FIG. 4A character could be replaced with a large X character, so that the instability indicating symbol would be a sequence of X's instead of a filled rectangle. The characters of FIGS. 4B-4D are chosen so that a quiescent period is represented by "stability indicating symbol" comprising a light rectangle with or without a state indicating number therein or by single "high" or "low" lines wherein the length of the rectangle or line represents the duration of a stable time period. However, stability indicating symbols comprising graphical representations other than lines and rectangles could be created by changing the nature of the characters of FIGS. 4B-4E.

The data values shown superimposed over the busform sections in FIG. 2 could be displayed, for instance, over or under the relevant busform section. Also the busform may be drawn using different methods and apparatus known in the prior art for producing graphical displays other than by utilizing a set of special graphics characters although the latter is preferred.

Accordingly, while a preferred embodiment of the present invention has been shown and described, it will be apparent to those skilled in the art that many changes and modifications may be made without departing from the invention in its broader aspects. The appended claims are therefore intended to cover all such changes and modifications as fall within the true spirit and scope of the invention.

**Claims**

1. A method for displaying the timing and state characteristics of a group of logic signals comprising the steps of:
monitoring the state of each logic signal of said group;
determining quiescent periods during which none of said logic signals changed state; and
displaying a sequence of stability indicating symbols on a screen, the length of each stability indicating symbol representing the duration of a different one of said quiescent periods, the stability indicating symbols being displayed in order of occurrence of represented quiescent periods.

2. The method according to claim 1 wherein said stability indicating symbols comprise rectangles.

3. The method according to claim 1 further comprising the step of displaying on said screen a numerical indication of the states of said logic signals as said logic signals existed during one said quiescent period, the numerical indication being juxtaposed with the stability indicating symbol representing said one quiescent period.

4. A method for displaying the timing and state characteristics of a group of logic signals comprising the steps of:
monitoring the state of each logic signal of the group;
determining quiescent periods during which none of said logic signals changed state and transition periods during which at least one of said logic signals changed state; and
displaying a sequence of stability indicating symbols on a screen, the length of each stability indicating symbol representing the duration of one of said quiescent periods, said stability indicating symbols being displayed in order of occurrence of the represented quiescent periods, said stability indicating symbols being separated by a distance proportional to transition periods occurring between said quiescent periods.

5. A method for displaying the timing and state characteristics of a group of logic signals comprising the steps of:
monitoring the state of each logic signal of the group;
determining quiescent periods during which none of the logic signals changed state and transition periods during which at least one of the logic signals changed state; and
displaying a sequence of stability and instability indicating symbols on a screen, the length of each stability indicating symbol representing the duration of a different one of said quiescent periods and the length of each instability indicating symbol representing the duration of a different one of said transition periods, said stability and instability indicating symbols being displayed in order of occurrence of said represented quiescent and transition periods.

6. The method according to claim 5 wherein said stability indicating symbols comprise rectangles.

7. The method according to claim 5 further comprising the step of displaying on said screen a numerical indication of the states of said logic signals as said logic signals existed during one of said quiescent periods represented by a stability indicating symbol, the numerical indication being juxtaposed with said one stability indicating symbol.

8. An apparatus for displaying the timing and state characteristics of a group of logic signals comprising:

means for monitoring the state of each logic signal of the group and for storing data in a memory representing states of said logic signals at a succession of times; and

means for determining from said stored data quiescent periods during which none of said logic signals changed state and for displaying a sequence of stability indicating symbols on a screen, the length of each stability indicating symbol representing the duration of a different one of said quiescent periods, said stability indicating symbols being displayed in order of occurrence of said quiescent periods.

9. An apparatus for displaying the timing and state characteristics of a group of logic signals comprising:

means for monitoring the state of each logic signal of the group and for storing data in a memory representing said logic signal states at a succession of times; and

means for determining from said stored data quiescent periods during which none of said logic signals changed state, for displaying a sequence of stability indicating symbols on a screen, the length of each stability indicating symbol representing the duration of a different one of said quiescent periods, said stability indicating symbols being displayed in the order that said quiescent periods occurred, and for displaying on the screen a numerical indication of the states of said logic signals as said logic signals existed during one of said quiescent periods represented by a stability indicating symbol, the numerical indication being juxtaposed with said stability indicating symbol.

10. An apparatus for displaying the timing and state characteristics of a group of logic signals comprising:

means for monitoring the state of each logic signal of the group and for storing data in a memory representing states of said logic signals at a succession of times;

means for determining from said stored data quiescent periods during which none of said logic signals changed state and for determining transition periods during which at least one of said logic signals changed state; and

means for displaying a sequence of stability indicating symbols on a screen, the length of each stability indicating symbol representing the duration of a different one of said quiescent periods, the stability indicating symbols being displayed in order of occurrence of said quiescent periods, said stability indicating symbols being separated by a distance proportional to transition periods between said quiescent periods represented by said stability indicating signals.

11. An apparatus for displaying the timing and state characteristics of a group of logic signals comprising:

means for monitoring the state of each logic signal of the group; and

means for determining quiescent periods during which none of said logic signals changed state and transition periods during which at least one of said logic signals changed state, and for displaying a sequence of stability and instability indicating symbols on a screen, the length of each stability indicating symbol representing the duration of a different one of said quiescent periods and the length of each instability indicating symbol representing the duration of a different one of said transition periods, the stability and instability indicating symbols being displayed in order of occurrence of said quiescent and transition periods.

FIG. 1

CH1

CH2

CH3

CH 4-19   40 41   42   44   0001   0003   4D21   4D21

CH20-35   9D21   134A   214F   223D

T1   T2 T3   T4 T5 T6   T7   T8   T9

FIG. 2

FIG.4A   FIG.4B   FIG.4C   FIG.4D   FIG.4E

FIG. 3

0 245 915

# FIG. 5

START — 70

J = 0
K = 0 — 72

74 — K:LIM — > STOP — 76

78 — CHANGE DURING K — NO → J = J+1 (80) → K = K+1 (82)

YES

84 — J=0 — YES → STORE CHAR A (86)

NO

J = 0 (92)

88 — DATA ALL HI DURING K-1 — YES → STORE J CHAR D's (90)

NO

94 — DATA ALL LO DURING K-1 — YES → STORE J CHAR E's (96)

NO

98 — J<WL — YES → STORE J CHAR B's (100)

NO

N = (J-WL)/2 (102)

STORE N CHAR B (104) → STORE WL CHAR C's (106) → STORE J-WL-N CHAR B's (108)